# EUROPEAN PATENT SPECIFICATION

(11) **EP 3 916 933 B1**
(45) Date of publication and mention of the grant of the patent: **05.07.2023**
(21) Application number: 21174991.6
(22) Date of filing: 20.05.2021
(51) Int. Cl.: H01S 5/02234, H01S 5/0232, H01L 23/00, H01L 33/48, H01L 21/56, H01L 23/31, H01L 23/482, H01L 23/495, H01S 5/026, H01S 5/40

(54) **SEMICONDUCTOR SIDE EMITTING LASER LEADFRAME PACKAGE AND METHOD OF PRODUCING SAME**
LEITERRAHMENGEHÄUSE FÜR SEITLICH ABSTRAHLENDEN HALBLEITERLASER UND VERFAHREN ZUR HERSTELLUNG DAVON
BOÎTIER RÉSEAU DE CONDUCTEURS À LASER À ÉMISSION LATÉRALE SEMI-CONDUCTEUR ET SON PROCÉDÉ DE PRODUCTION

(30) Priority: 26.05.2020 US 202016882858
(43) Date of publication of application: 01.12.2021
(73) Proprietor: Excelitas Canada Inc., Québec J7V 8P7 (CA)
(72) Inventor: JU, JinHan, Vaudreuil-Dorion, J7V 8P7 (CA); CHARLEBOIS, Gabriel, Vaudreuil-Dorion, J7V 8RS (CA)
(74) Representative: Mewburn Ellis LLP

(56) References cited:
- US-A1- 2007 278 511
- US-A1- 2010 015 329
- US-A1- 2018 145 013
- US-A1- 2018 254 605
- US-A1- 2019 312 407
- US-A1- 2020 144 786

## Description

### FIELD OF THE INVENTION

The present invention relates to electronic circuitry, and more particularly, is related to surface mount packaging for semiconductor emitters.

### BACKGROUND OF THE INVENTION

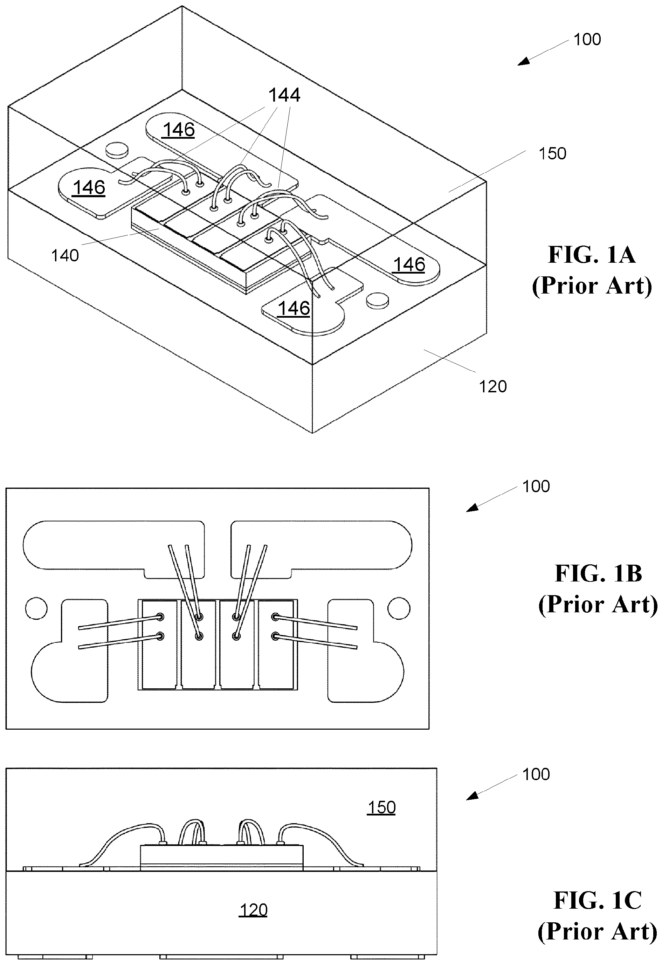

FIGS 1A-1C show an exemplary existing surface mount design (SMD) package 100 for a side emitting laser array 140. For example, as shown in FIG. 1B, a current SMD package 100, is shown with an array die of four side emitting semiconductor lasers 140 mounted on a substrate 120, for example, a printed circuit board (PCB) or a ceramic. The PCB or ceramic substrate 120 may be relatively thick with respect to the overall height of the package 110, for example, on the order of 30% to 50% of the overall package height.

A plurality of wire bond pads 146 are attached to the substrate 120, and a plurality of bond wires 144 electrically connect the laser array die 140 to the wire bond pads 146. The wire bond pads may be connected to surface mount pads 170 at the bottom of the package 100, where through vias (not shown) provide an electrical connection between the wire bond pads 146 and the surface mount pads 170. The electronic components are encapsulated with a transparent resin 150, for example an epoxy. The current SMD package 100 may have inductance and resistance that are too high for some application, for example a LIDAR application where the lasers must rapidly discharge and recharge. Therefore, there is a need in the industry to overcome the deficiencies in this area.

US 2019/312407 A1 and US 2018/254605 A1 each discloses a surface mount laser package for a side-looking semiconductor laser, comprising a substantially planar leadframe embedded in the base of a molding body housing, the leadframe having a top component side mounting the laser die in a cavity of the housing, and a bottom board attach side.

### SUMMARY OF THE INVENTION

Embodiments of the present invention provide a semiconductor side emitting laser leadframe package and method for producing the same. Briefly described, the present invention is directed to a surface mount laser package for a side-looking semiconductor laser, as defined in claim 1, and to a method as defined in claim 7 for forming the semiconductor side emitting laser surface mount package of claim 1. The package has a substantially planar leadframe with a component side and a board attach side. The component side has a conductive die attach pad and a plurality of wire bond pads. A laser die has an anode surface and a cathode surface, where the cathode surface is mounted to the conductive die attach pad. A plurality of bond wires span between the laser die anode surface and a wire bond pad. A molding encases the laser die and the plurality of bond wired on the component side of the leadframe and also lies between the conductive die attach pad and each of the wire bond pads within a plane of the leadframe. The conductive die attach pad has a metallization layer on the leadframe and each of the bond pads has a metallization layer on the leadframe.

Other systems, methods and features of the present invention will be or become apparent to one having ordinary skill in the art upon examining the following drawings and detailed The scope of the present invention is defined by the accompanying claims.

### BRIEF DESCRIPTION OF THE DRAWINGS

The accompanying drawings are included to provide a further understanding of the invention, and are incorporated in and constitute a part of this specification. The drawings illustrate embodiments of the invention and, together with the description, serve to explain the principals of the invention.
FIG. 1A is a schematic diagram of an exemplary existing surface mount design (SMD) package for a side emitting laser array shown from a perspective view.
FIG. 1B is a schematic diagram of the SMD package of FIG. 1A shown from a top view.
FIG. 1C is a schematic diagram of the SMD package of FIG. 1A shown from a front side view.
FIG. 2 is a schematic diagram of an exemplary first embodiment of a semiconductor side emitting laser leadframe package shown from a perspective view.
FIG. 3A shows a top down view of the first embodiment package of FIG. 2.
FIG. 3B shows the package of FIG. 2 from a side view.
FIG. 3C show an isolated view of the leadframe of FIG. 2 from a top down view.
FIG. 4 shows the side emitting laser diodes of the laser array die of FIG. 2 emitting a laser beam through the mold compound.
FIG. 5A shows a matrix of leadframes under the first embodiment.
FIG. 5B shows a laser die and bond wires attached to one leadframe of FIG. 5A.
FIG. 5C shows the matrix of leadframes of FIG. 5A with laser dies and wire bonds attached.
FIG. 6 is a flowchart of an exemplary embodiment of a method for forming a semiconductor side emitting laser leadframe package.
FIG. 7 is a schematic diagram of a 3 by 10 array of leadframes of FIG. 5A with laser dies and wire bonds attached.

### DETAILED DESCRIPTION

The following definitions are useful for interpreting terms applied to features of the embodiments disclosed herein, and are meant only to define elements within the disclosure.

As used within this disclosure, "substantially" means "very nearly" or to within normal manufacturing tolerances. For example, a substantially parallel surface may be parallel to within acceptable tolerances, or a substantially flat surface is flat to within a specified measure of flatness. Similarly, a substantially undisturbed laser beam refers to a laser beam that is not significantly or noticeably altered (distorted or diverted) beyond acceptable operating tolerances.

As used within this disclosure, Surface-mount technology (SMT) refers to the mounting of electrical components directly onto the surface of a printed circuit board (PCB). An electrical component mounted in this manner is referred to as a surface-mount device (SMD). A SMD may be contrasted with through-hole technology construction for mounting components to a PCB by inserting component pins through holes in a circuit board, in large part because SMT allows for increased manufacturing automation.

As used within this disclosure, "molding" refers to a transfer molded sealing compound with high pressure for encasing electronic components of an SMT electronic package. In contrast, encapsulation, refers to a covering compound, for example a self-leveling epoxy potting over the electronic components.

Reference will now be made in detail to embodiments of the present invention, examples of which are illustrated in the accompanying drawings. Wherever possible, the same reference numbers are used in the drawings and the description to refer to the same or like parts.

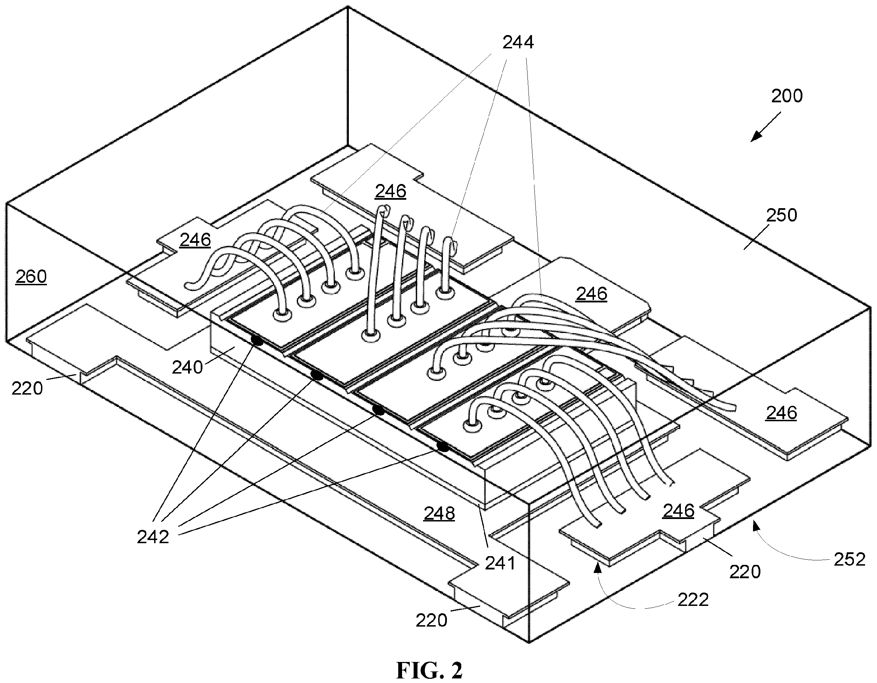

Exemplary embodiments of the present invention include devices and methods for producing SMD packages for one or more side emitting lasers. As shown in FIG. 2, an exemplary first embodiment 200 of the present invention includes a semiconductor side emitting laser die 240 having very low inductance and very low thermal resistance, at very low material and manufacturing cost in comparison with previous packages. The first exemplary embodiment includes a four channel laser die 240 attached on the very thin leadframe 220, gold or aluminum wires electrically connecting the die to the thin metal leadframe wire bond pads 246 and an encasing molding 250.

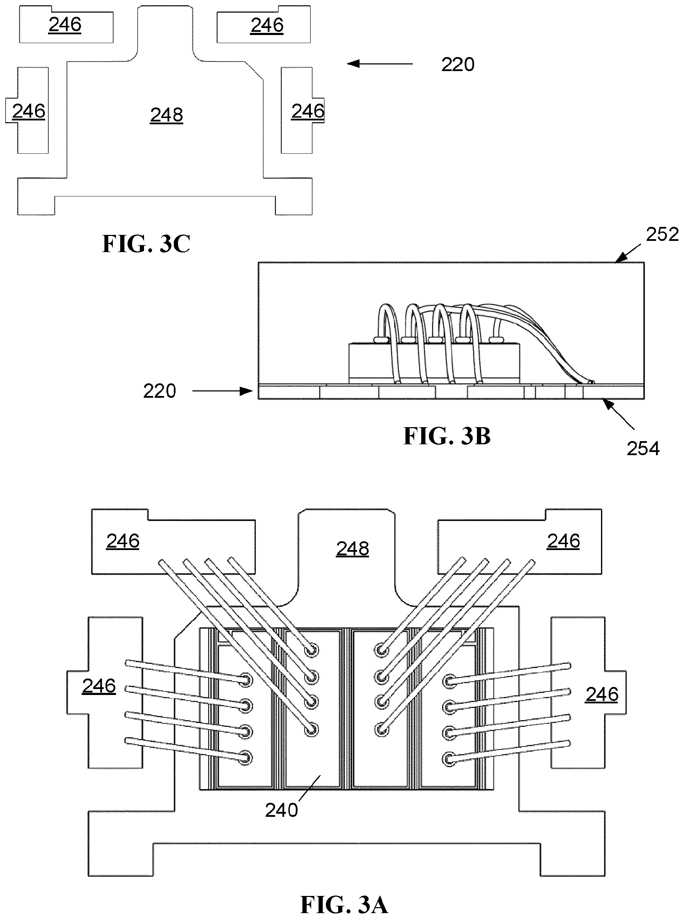

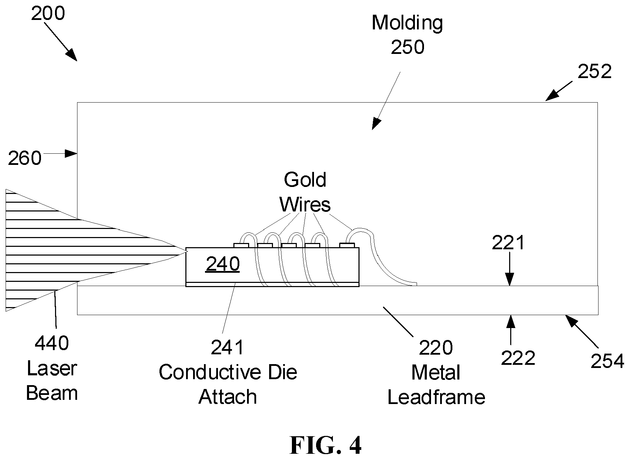

As shown by FIG. 4, under the first embodiment, the leadframe 220 is made of Nickel and plated with silver on a lead frame top surface 221 for gold wire bonding and laser die attach. A leadframe bottom surface 222 has a gold plating for mounting the package 200 on, for example, a PCB (not shown). In general, the bottom surface 254 of the package 200 is substantially coplanar with the leadframe bottom surface 222. Under the first embodiment, the leadframe thickness is on the order of about 65 microns thick to achieve very low inductance and very low thermal resistance. In alternative embodiments the leadframe thickness may be on the order of 50 microns to 250 microns thick. The laser die is attached to a conductive die pad 248 (FIG. 3C) on the metal leadframe 220 by thermally and electrically conductive material 241, for example, solder or epoxy.

Alternative embodiments of the package 200 may have a single side emitting laser diode instead of a laser diode array die 240 or may have an array die 240 with a different number of laser diodes, for example, two, eight, or sixteen, or more laser diodes.

FIG. 2 shows an exemplary first embodiment of a SMD package 200 having a laser array die 240 having four side emitter laser diodes, each laser diode having a side aperture 242 for emission of a laser beam in a direction substantially parallel to the leadframe 220 mounting surface. The leadframe 220 serves as a carrier for the laser die 240 and associated circuitry.

The package 200 includes an encasing molding 250, for example a molding material transparent to light emitted by the laser die array 240 encompassing the laser die 240 and the leadframe 220. Preferably, the molding material adheres well to the laser die and wire bonds and leadframe pads, is rigid enough to resist, for example, a temperature cycle test, the singulation process (described later), and surface polishing. For example, a desirable encasing molding material has a hardness greater than Shore D 70 at room temperature (23°C), and light transmission of greater 90% for light of 905 nm wavelengths. In particular, the molding extends from a top portion 252 of the package 200 to a bottom surface 254 of the package 200, so that the molding surrounds all exposed surfaces of the leadframe 220 except for a leadframe bottom surface 222.

Additional circuitry associated with the laser die 240 is situated on the leadframe 220 encased by the molding 250, comprising a plurality of wire bond pads 246 formed as a metallization layer on the leadframe 220, and a plurality of bond wires 244 electrically connecting the laser array die 240 to the wire bond pads 246. In alternative embodiments, other circuit components may additionally be encased within the molding 250, for example, capacitors, driver circuitry, and the like.

FIG. 3A shows a top down view of the first embodiment package 200. FIG. 3A shows the package 200 from a top view. FIG. 3B shows the package 200 from a side view. FIG. 3C show an isolated view of the leadframe 220, identifying the mounting surfaces 246, 248.

As shown by FIG. 4, the side emitting laser diodes of the laser array die 240 are oriented to emit laser beams 440 through the molding 250 so that the laser beams exit the package 200 through an egress surface 260 of the molding 250.

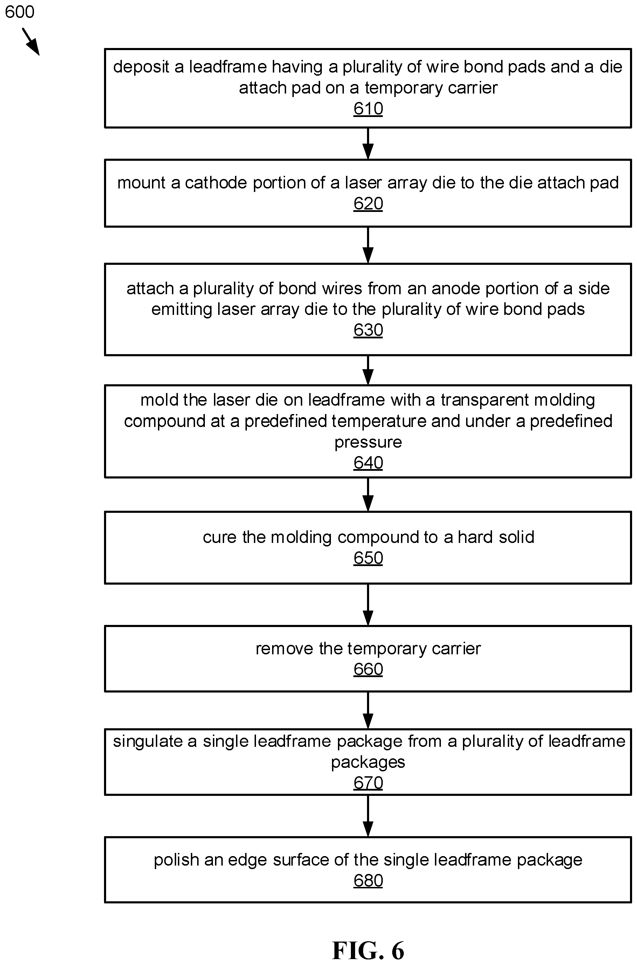

FIG. 6 is a flowchart of an exemplary embodiment of a method 600 for forming a semiconductor side emitting laser leadframe package. It should be noted that any process descriptions or blocks in flowcharts should be understood as representing modules, segments, portions of code, or steps that include one or more instructions for implementing specific logical functions in the process, and alternative implementations are included within the scope of the present invention in which functions may be executed out of order from that shown or discussed, including substantially concurrently or in reverse order, depending on the functionality involved, as would be understood by those reasonably skilled in the art of the present invention. The method of FIG. 6 is described with respect to the first embodiment of FIG. 2.

A leadframe 220 having a plurality of wire bond pads 246 and a die attach pad 248 is deposited on a temporary carrier (not shown), as shown by block 610. For example, the leadframe 220 may be removably attached to the temporary carrier via a removable adhesive. Alternatively, the temporary carrier itself may be a strip of removable adhesive material. In another alternative embodiment, the bottom surface of the 220 may be coated with a masking material that is removed during the manufacturing process to expose the leadframe 220 material and/or a thermally and/or electrically conductive metallization layer at the bottom of the leadframe 220. A cathode (bottom) portion of a laser array die 240 is mounted to the die attach pad 248, as shown by block 620. For example, the laser array die 240 cathode may be mounted to the die attach pad 248 with an electrically and thermally conductive material. A plurality of bond wires 244 spanning from an anode (top) portion of the side emitting laser array die 240 are attached to the plurality of wire bond pads 246, as shown by block 630. The laser die 240 is molded on and around the leadframe with a transparent molding compound 250 at a predefined temperature and under a predefined pressure, as shown by block 640. The molding compound 250 is cured to a hard solid, as shown by block 650. The temporary carrier is removed, as shown by block 660, so the leadframe 220 at the bottom surface of the package 200 is substantially coplanar with a bottom surface of the molding 250.

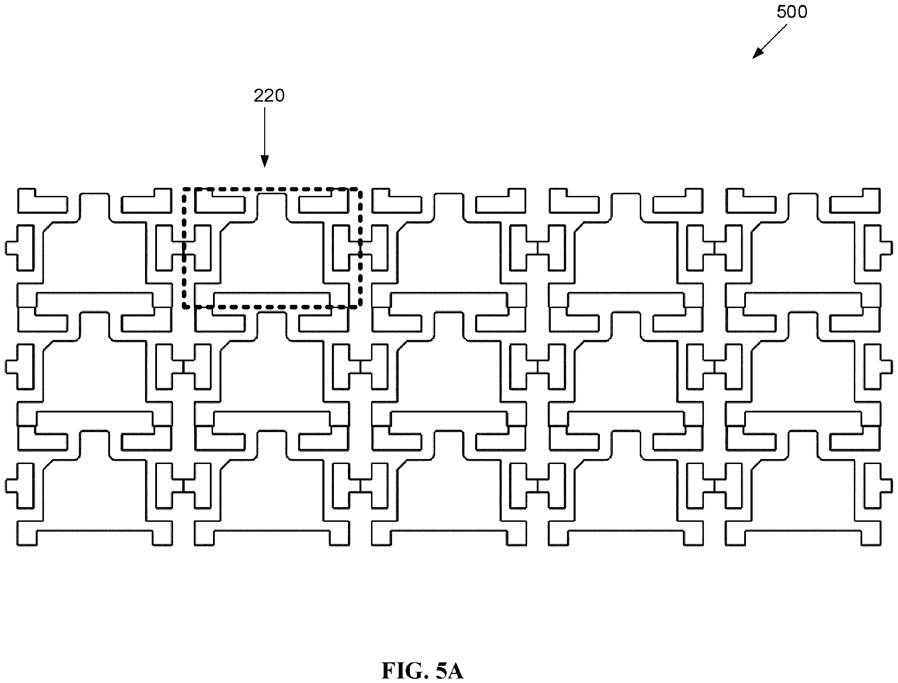

For manufacturing, the leadframe 220 may be one section of a matrix or array of leadframes 500, as shown by FIG. 5A, facilitating co-production of multiple packages 200 at once. While FIG. 5A shows a 3 by 5 matrix for clarity, in practice the matrix 500 may be considerably larger, for example, a metal leadframe strip matrix of 20 by 63 matrix yielding 1260 units per strip.

Returning to FIG. 6, a single leadframe package is singulated from a plurality of leadframe packages, as shown by block 670. An edge surface of the single leadframe package is polished, as shown by block 680.

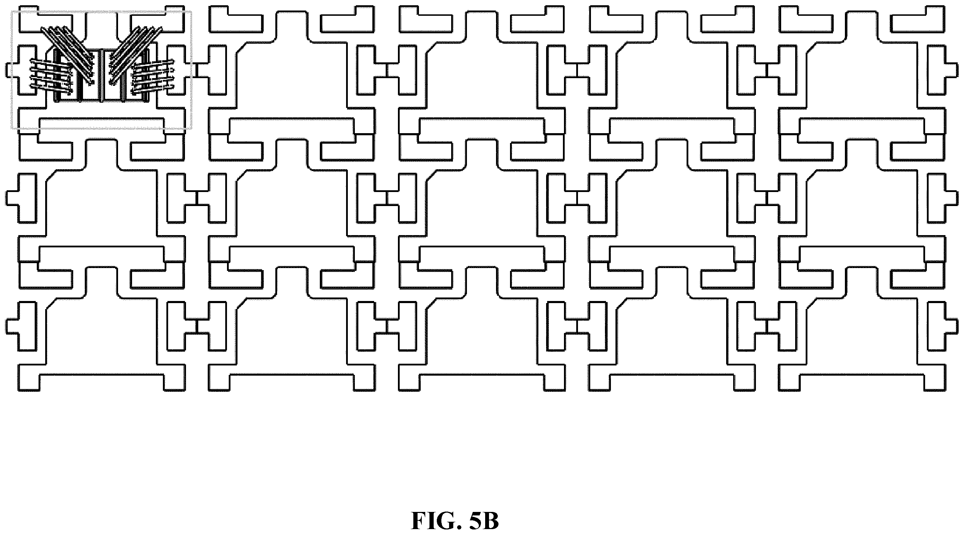

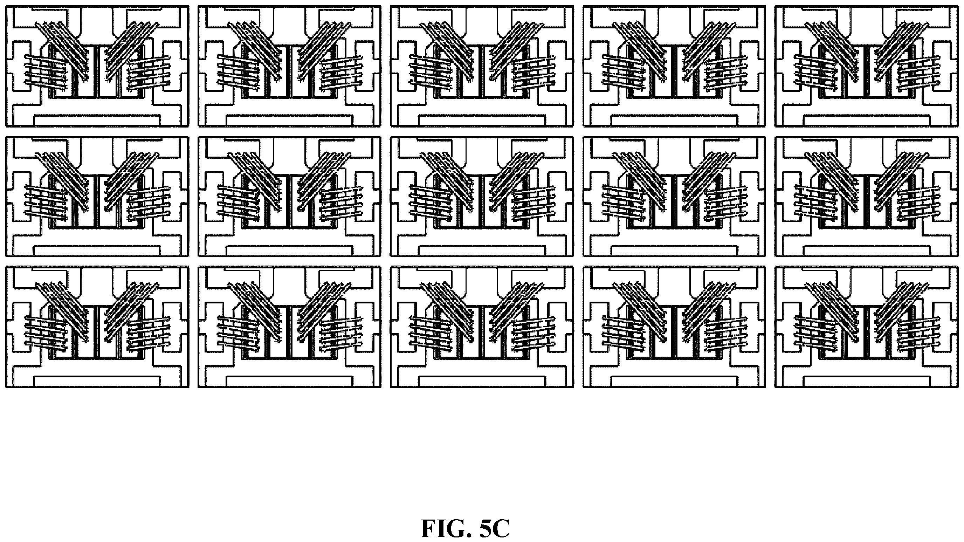

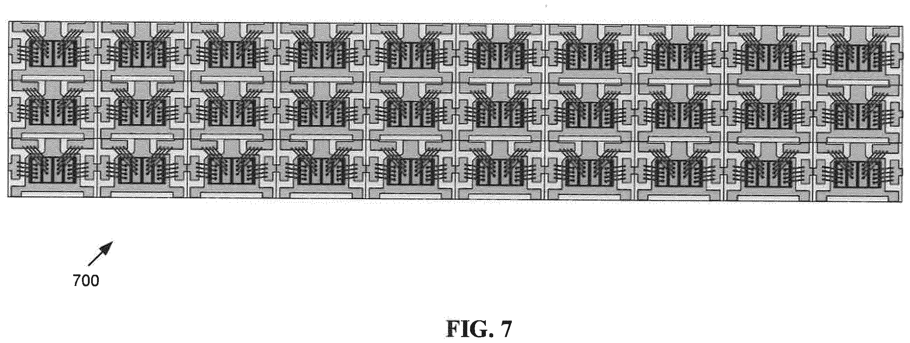

The laser die 240 is attached to each lead frame portion 220, as shown by FIG. 5B. Here, the bottom (cathode) of the laser die 240 (FIG. 2) is attached upon the leadframe 220 using an electrically and thermally conductive material. Gold bonding wires 244 (FIG. 2) are attached to an anode (top portion) of the laser die 240 to wire bond pads 246 (FIG. 2) on the leadframe 220 (FIG. 2). While FIG. 5B shows the attachment of a single laser die for clarity, in general the laser dies and wire bonds are attached to all of the lead frame portions during the same manufacturing step, as shown by FIG. 5C. The laser dies 240 are molded on leadframe 220, for example with a transfer molding machine, using a transparent molding compound at a predetermined temperature and under a predetermined pressure. The molding compound is cured at a predetermined temperature and time period to a hard solid. FIG 7 shows an exemplary 3 by 10 matrix 700.

After the molding compound has cured, the packages 200 are singulated into individual units. After singulation, at least one surface 260 of the molding may be polished to allow emission of a laser beam from the laser array die 240, for example, an egress surface 260 of the molding adjacent to an emitter of the laser array die 240.

The present embodiments have several advantages over the previous semiconductor laser packages 100 (FIGS. 1A-1C). For example, the package 200 under the present embodiment may be considerably smaller than the previous package 100. Typically, the previous package 100 for a 4-channel laser on a PCB substrate has a footprint on the order of 3.5 mm by 2.0mm and a height of 1.65mm. In contrast, under the present embodiment a 4-channel laser on a leadframe package 200 footprint may have a footprint area of 2.6 mm by 1.7, that is 4.4mm², comparing with a 7.0 mm² footprint of the previous package, or 63% of previous package footprint. The height of the package 200 is on the order of 0.60 mm compared with 1.65mm for the previous package 100, or 36% of the height of the previous package 100.

Because the leadframe 220 of the present embodiment package 200 is considerably thinner than the PCB or ceramic substrate 120 of the previous package 100, under the present embodiments, the thinner leadframe 220 necessarily results in shorter electrical connection distances between the laser die 240 and the host PCB (not shown) than the distance between the laser die 140 and the host PCB in the previous package. The longer electrical connection distances of the previous package 100 result in greater inductance and thermal resistance in comparison with the package 200 of the present embodiments. The thermal resistance of the previous package 100 is on the order of at least 20° C/W, whereas the thermal resistance of the package 200 under the present embodiment may be on the order of less than 5° C/W, or less than 25% of the thermal resistance compared with the previous package 100. In practical terms, this may result in higher reliability and longer laser lifetime for the present embodiment package 200.

Also due to the shorter electrical connection distances of the package 200 under the current embodiments, the inductance may be decreased, for example, from on the order of greater than 1.3 nH to less than 0.3 nH, or less than 25% of the inductance of the previous package 100. This may facilitate laser performance improvement of the present package, for example, shorter laser pulse width.

In addition, there may be significant cost savings for producing the present embodiments in comparison with the previous package 100, for example, by eliminating the fabrication of a PCB substrate 120, the use of less expensive components, and the use of less material overall due to the smaller size. The leadframe design makes possible of making hundreds and thousands of small packages in very short cycle time.

In summary, it will be apparent to those skilled in the art that various modifications and variations can be made to the structure of the present invention without departing from the scope of the invention. In view of the foregoing, it is intended that the present invention cover modifications and variations of this invention provided they fall within the scope of the following claims.

## Claims

1. A surface mount laser package (200) for a side-looking semiconductor laser, comprising:
an electronic assembly, comprising:
a substantially planar leadframe (220) with a component side and a board attach side, the component side further comprising a conductive die attach pad (248) and a plurality of wire bond pads (246);
a laser die (240) comprising an anode surface and a cathode surface, the cathode surface mounted to the conductive die attach pad; and
a plurality of bond wires (244), each bond wire comprising a first end in electrical communication with the laser die anode surface and a second end in electrical communication with a wire bond pad of the plurality of wire bond pads; and
a rigid structure consisting of:
a cured molding (250) encasing the laser die and the plurality of bond wires on the component side of the leadframe and further disposed between the conductive die attach pad and each of the plurality of wire bond pads within a plane of the leadframe,
wherein a bottom surface of the laser package comprises a surface of said cured molding and the leadframe board attach side, and the molding surrounds all surfaces of the leadframe except for the leadframe board attach side.

2. The surface mount laser package (200) of claim 1, wherein the conductive die attach pad comprises a metallization layer on the leadframe and each of the plurality of wire bond pads comprises a metallization layer on the leadframe.

3. The surface mount laser package (200) of claim 1, wherein the leadframe has a thickness on the order of 65 microns.

4. The surface mount laser package (200) of claim 1, wherein the molding encasing comprises a thermosetting polymer material.

5. The surface mount laser package (200) of claim 4, wherein the thermosetting polymer material is transparent to the light from the laser die.

6. The surface mount laser package (200) of claim 4, wherein the thermosetting polymer material is compatible to the transfer molding process.

7. A method for forming the semiconductor side emitting laser surface mount package (200) of claim 1, comprising the steps of:
depositing a substantially planar leadframe (220) comprising a plurality of wire bond pads (246) and a die attach pad (248) on a temporary carrier;
mounting a cathode portion of a laser die (240) to the die attach pad;
attaching a plurality of bond wires (244) from an anode portion of a side emitting laser die to the plurality of wire bond pads;
molding the laser die on leadframe with a transparent molding compound, at a predefined temperature and under a predefined pressure, wherein the molding (250) surrounds all surfaces of the leadframe except for the leadframe board attach side;
curing the molding compound to a hard solid;
removing the temporary carrier; and
singulating a single leadframe package from a plurality of leadframe packages between the attach pads of the plurality of leadframe packages.

8. The method of claim 7, wherein the laser die cathode is mounted to the die attach pad with an electrically and thermally conductive material.

9. The method of claim 7, wherein the leadframe is a section of a leadframe matrix

10. The method of claim 7, wherein the leadframe is attached to the temporary carrier via an adhesive.

11. The method of claim 7, further comprising the step of polishing a surface of the molding adjacent to an emitter of the laser die.

12. The method of claim 7, wherein the transparent molding compound comprises a thermosetting polymer material.

13. The method of claim 7, further comprising the step of polishing an edge surface of the single leadframe package.

## Patentansprüche

1. An Oberflächen montierbares Lasergehäuse (200) für einen Seitensichthalbleiterlaser, das Folgendes umfasst:
eine Elektronikanordnung, die Folgendes umfasst:
einen im Wesentlichen ebenen Leiterrahmen (220) mit einer Komponentenseite und einer Platinenbefestigungsseite, wobei die Komponentenseite außerdem eine leitfähige Nacktchipbefestigungskontaktstelle (248) und eine Vielzahl von Drahtbondkontaktstellen (246) umfasst;
einen Lasernacktchip (240), der eine Anodenoberfläche und eine Kathodenoberfläche umfasst, wobei die Kathodenoberfläche an der leitfähigen Nacktchipbefestigungskontaktstelle montiert ist; und
eine Vielzahl von Bonddrähten (244), wobei jeder Bonddraht ein erstes Ende in elektrischer Kommunikation mit der Lasernacktchip-Anodenoberfläche und ein zweites Ende in elektrischer Kommunikation mit einer Drahtbondkontaktstelle aus der Vielzahl von Drahtbondkontaktstellen umfasst; und
eine starre Struktur, die aus Folgendem besteht:
einem ausgehärteten Formteil (250), das den Lasernacktchip und die Vielzahl von Bonddrähten auf der Komponentenseite des Leiterrahmens umhüllt und außerdem zwischen der leitfähigen Nacktchipbefestigungskontaktstelle und jeder aus der Vielzahl von Drahtbondkontaktstellen innerhalb einer Ebene des Leiterrahmens angeordnet ist,
wobei eine Bodenfläche des Lasergehäuses eine Oberfläche des ausgehärteten Formteils und der Leiterrahmen-Platinenbefestigungsseite umfasst und das Formteil alle Oberflächen des Leiterrahmens mit Ausnahme der Leiterrahmen-Platinenbefestigungsseite umgibt.

2. An Oberflächen montierbares Lasergehäuse (200) nach Anspruch 1, wobei die leitfähige Nacktchipbefestigungskontaktstelle eine Metallisierungsschicht auf dem Leiterrahmen umfasst und jede aus der Vielzahl von Drahtbondkontaktstellen eine Metallisierungsschicht auf dem Leiterrahmen umfasst.

3. An Oberflächen montierbares Lasergehäuse (200) nach Anspruch 1, wobei der Leiterrahmen eine Dicke in der Größenordnung von 65 µm aufweist.

4. An Oberflächen montierbares Lasergehäuse (200) nach Anspruch 1, wobei die Formteilumhüllung ein duroplastisches Polymermaterial umfasst.

5. An Oberflächen montierbares Lasergehäuse (200) nach Anspruch 4, wobei das duroplastische Polymermaterial gegenüber dem Licht aus dem Lasernacktchip transparent ist.

6. An Oberflächen montierbares Lasergehäuse (200) nach Anspruch 4, wobei das duroplastische Polymermaterial mit dem Spritzpressverfahren kompatibel ist.

7. Verfahren zum Ausbilden des an Oberflächen montierbaren Gehäuses für einen seitlich emittierenden Halbleiterlaser (200) nach Anspruch 1, das die folgenden Schritte umfasst:
das Aufbringen eines im Wesentlichen ebenen Leiterrahmens (220), der eine Vielzahl von Drahtbondkontaktstellen (246) und eine Nacktchipbefestigungskontaktstelle (248) umfasst, auf einem temporären Träger;
das Montieren eines Kathodenabschnitts eines Lasernacktchips (240) an der Nacktchipbefestigungskontaktstelle;
das Befestigen einer Vielzahl von Bonddrähten (244) von einem Anodenabschnitt eines Nacktchips eines seitlich emittierenden Lasers an der Vielzahl von Drahtbondkontaktstellen;
das Eingießen des Lasernacktchips auf dem Leiterrahmen mit einer transparenten Formverbindung bei einer vorbestimmten Temperatur und mit vorbestimmtem Druck, wobei das Formteil (250) alle Oberflächen des Leiterrahmens mit Ausnahme der Leiterrahmen-Platinenbefestigungsseite umgibt;
das Aushärten der Formverbindung zu einem harten Feststoff;
das Entfernen des temporären Trägers; und
das Vereinzeln eines einzelnen Leiterrahmengehäuses aus einer Vielzahl von Leiterrahmengehäusen zwischen den Befestigungskontaktstellen der Vielzahl von Leiterrahmengehäusen.

8. Verfahren nach Anspruch 7, wobei die Lasernacktchipkathode an der Nacktchipbefestigungskontaktstelle mit einem elektrisch und thermisch leitfähigen Material montiert ist.

9. Verfahren nach Anspruch 7, wobei der Leiterrahmen ein Teil einer Leiterrahmenmatrix ist.

10. Verfahren nach Anspruch 7, wobei der Leiterrahmen mit einem Klebstoff an dem temporären Träger befestigt ist.

11. Verfahren nach Anspruch 7, das außerdem den Schritt des Polierens einer Oberfläche des Formteils benachbart zu einem Emitter des Lasernacktchips umfasst.

12. Verfahren nach Anspruch 7, wobei die transparente Formverbindung ein duroplastisches Polymermaterial umfasst.

13. Verfahren nach Anspruch 7, das außerdem den Schritt des Polierens einer Kantenoberfläche des einzelnen Leiterrahmengehäuses umfasst.

## Revendications

1. Boîtier laser à montage en surface (200) pour un laser à semi-conducteur à visée latérale, comprenant :
un ensemble électronique, comprenant :
une grille de connexion sensiblement plane (220) ayant un côté composants et un côté fixation de carte, le côté composants comprenant en outre une pastille de fixation de puce conductrice (248) et une pluralité de pastilles de connexion de fil (246) ;
une puce laser (240) comprenant une surface d'anode et une surface de cathode, la surface de cathode étant montée sur la pastille de fixation de puce conductrice ; et
une pluralité de fils de connexion (244), chaque fil de connexion comprenant une première extrémité en communication électrique avec la surface d'anode de puce laser et une seconde extrémité en communication électrique avec une pastille de connexion de fil de la pluralité de pastilles de connexion de fil ; et
une structure rigide constituée de :
un moulage durci (250) renfermant la puce laser et la pluralité de fils de connexion sur le côté composants de la grille de connexion et disposé en outre entre la pastille de fixation de puce conductrice et chacune de la pluralité de pastilles de connexion de fil dans un plan de la grille de connexion,
dans lequel une surface inférieure du boîtier laser comprend une surface dudit moulage durci et du côté fixation de carte de grille de connexion, et le moulage entoure toutes les surfaces de la grille de connexion à l'exception du côté fixation de carte de grille de connexion.

2. Boîtier laser à montage en surface (200) selon la revendication 1, dans lequel la pastille de fixation de puce conductrice comprend une couche de métallisation sur la grille de connexion et chacune de la pluralité de pastilles de connexion de fil comprend une couche de métallisation sur la grille de connexion.

3. Boîtier laser à montage en surface (200) selon la revendication 1, dans lequel la grille de connexion a une épaisseur de l'ordre de 65 microns.

4. Boîtier laser à montage en surface (200) selon la revendication 1, dans lequel le moulage de renfermement comprend un matériau polymère thermodurcissable.

5. Boîtier laser à montage en surface (200) selon la revendication 4, dans lequel le matériau polymère thermodurcissable est transparent vis-à-vis de la lumière provenant de la puce laser.

6. Boîtier laser à montage en surface (200) selon la revendication 4, dans lequel le matériau polymère thermodurcissable est compatible avec le processus de moulage par transfert.

7. Procédé de formation du boîtier laser à semi-conducteur à montage en surface et à émission latérale (200) selon la revendication 1, comprenant les étapes consistant à :
déposer une grille de connexion sensiblement plane (220) comprenant une pluralité de pastilles de connexion de fil (246) et une pastille de fixation de puce (248) sur un support temporaire ;
monter une partie de cathode d'une puce laser (240) sur la pastille de fixation de puce ;
fixer une pluralité de fils de connexion (244) depuis une partie d'anode d'une puce laser à émission latérale à la pluralité de pastilles de connexion de fil ;
mouler la puce laser sur la grille de connexion avec un composé de moulage transparent, à une température prédéfinie et sous une pression prédéfinie, le moulage (250) entourant toutes les surfaces de la grille de connexion à l'exception du côté fixation de carte de grille de connexion ;
durcir le composé de moulage en un matériau solide dur ;
retirer le support temporaire ; et
séparer un boîtier à grille de connexion unique parmi une pluralité de boîtiers à grille de connexion entre les pastilles de fixation de la pluralité de boîtiers à grille de connexion.

8. Procédé selon la revendication 7, dans lequel la cathode de puce laser est montée sur la pastille de fixation de puce avec un matériau électriquement et thermiquement conducteur.

9. Procédé selon la revendication 7, dans lequel la grille de connexion est une section d'une matrice de grilles de connexion.

10. Procédé selon la revendication 7, dans lequel la grille de connexion est fixée au support temporaire via un adhésif.

11. Procédé selon la revendication 7, comprenant en outre l'étape de polissage d'une surface du moulage adjacente à un émetteur de la puce laser.

12. Procédé selon la revendication 7, dans lequel le composé de moulage transparent comprend un matériau polymère thermodurcissable.

13. Procédé selon la revendication 7, comprenant en outre l'étape de polissage d'une surface de bord du boîtier à grille de connexion unique.
